# EUROPEAN PATENT SPECIFICATION

(11) **EP 1 592 129 B1**
(45) Date of publication and mention of the grant of the patent: **25.07.2007**
(21) Application number: 04252566.7
(22) Date of filing: 30.04.2004
(51) Int. Cl.: H03G 3/30

(54) **Ramp circuit**
Rampenerzeugungsschaltung
Circuit pour engendrer un signal de rampe

(43) Date of publication of application: 02.11.2005
(73) Proprietor: Renesas Technology Europe Limited, Bourne End, Bucks SL8 5FH (GB)
(72) Inventor: Tolson, Nigel James, Reading Berkshire, RG8 8BS (GB)
(74) Representative: Read, Matthew Charles

(56) References cited:
- WO-A-02/093759
- GB-A- 2 241 124
- US-A1- 2004 038 701
- US-B1- 6 169 886

## Description

The invention relates to a ramp circuit and a method for controlling power supplied to a transmitter that is suitable for use in a Time Division Multiple Access (TDMA) system.

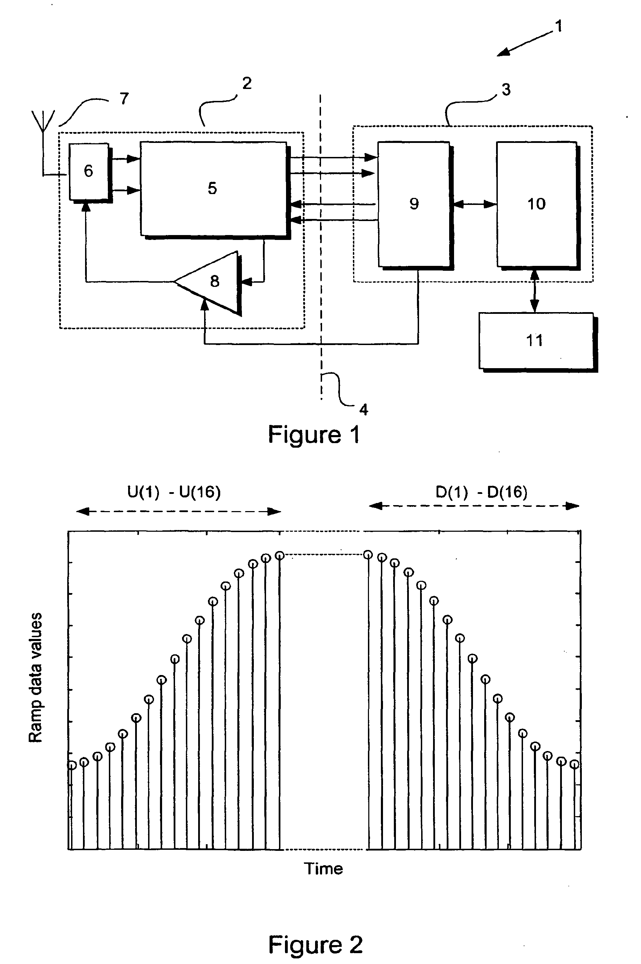

Figure 1 shows an example of a prior digital radio communication device 1, such as a mobile telephone. The device 1 comprises two subsystems: a radio portion 2 and a baseband portion 3, which can communicate via an analogue interface 4. The radio portion 2 includes a transceiver integrated circuit (IC) 5, a front end module 6 through which data is to be transmitted by, or data received by, antenna 7 is passed. A power amplifier 8 is used to control power supplied to the front end module 6. The baseband portion 3 comprises an analogue baseband processor 9 and a digital baseband processor 10, which has access to a memory facility 11.

In a TDMA system, such as the GSM system, the transmitter within the front end module 6 of the device 1 is activated at the start of a given transmission time slot and deactivated at the end of that time slot. In order to avoid generation of large switching transients, and therefore noise, the power supplied by the transmitter is ramped up and down in stages at the start and end of the time slot respectively. A ramp circuit controls this process and a maximum power level to be supplied during the time slot in accordance with ramp up values and ramp down values. The ramp up values and ramp down values are stored in the memory facility 11 and retrieved by the analogue baseband processor 9 before each relevant time slot.

Figure 2 depicts an example set of ramp values which determine the power applied to a power control circuit during a time slot. The dotted lines in Figure 2 indicate a break, relating to a part of the time slot for which maximum power is supplied to the power amplifier.

The ramp values U(1)-U(16), D(1)-D(16) are usually based on a raised cosine function, as such a function has a low spectral content and so gives rise to limited switching transient energy. In conventional arrangements, there are 16 ramp up values U(1)-U(16) and 16 ramp down values D(1)-D(16) for each time slot, where the 16^{th} ramp up value U(16) defines the maximum power level supplied by the transmitter during the relevant time slot. The ramp values are evenly spaced in time and provide data on the ramp shape at a low sample rate.

The shape of the ramp is set during manufacture of the mobile telephone 1 and the ramp values are stored in a non-volatile portion of the memory facility 11.

Although the form of the ramp may vary between different timeslots in a TDMA scheme, it is subject to a number of restrictions. While it is desirable to maximise a portion of the time slot for which the transmitter supplies the maximum power, which is therefore useable for data transmission, it is also necessary to limit switching transient noise, as this may interfere with other communication devices and affect network capacity.

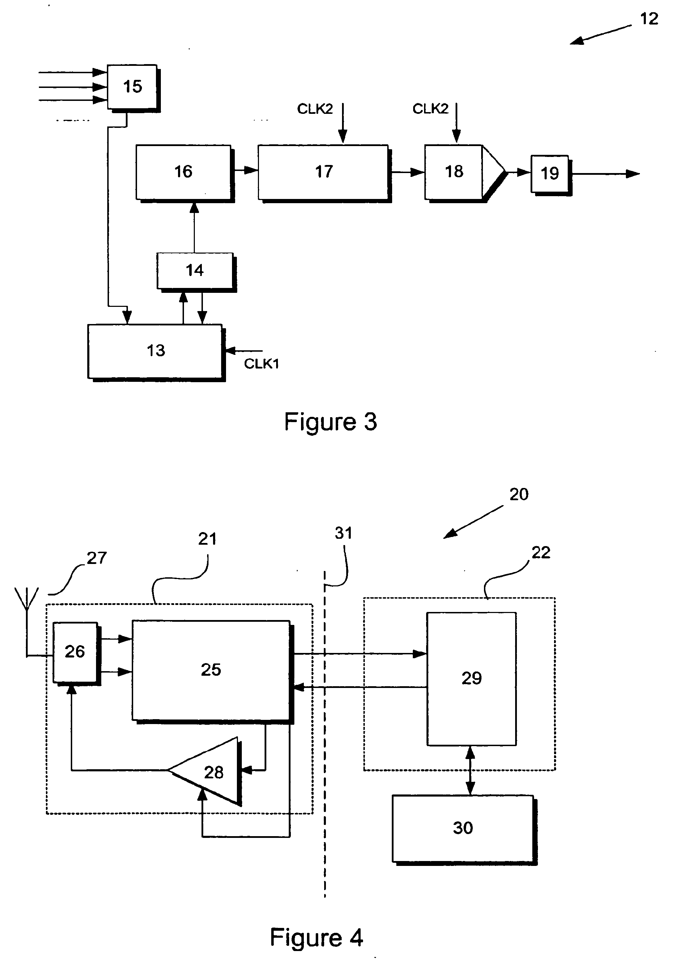

The ramping of the transmitter power is controlled by a ramp circuit within the analogue baseband processor 9. An example of a prior ramp circuit 12 is shown in Figure 3 and comprises a control circuit 13, together with an associated counter 14. The control circuit 13 receives the ramp values retrieved from the memory facility 11 via a serial interface 15 and stores them in a data storage facility 16 at the beginning of a time slot. The ramp values should not be uploaded during a preceding time slot, as this may result in interference with the data being transmitted or received.

An interpolator 17 is arranged to generate further ramp values based on the uploaded ramp values using linear interpolation. This effectively increases the sampling rate by a factor that is typically between 2 and 24, depending on the interpolation rate of the interpolator 17, resulting in a series of between 64 and 768 ramp values for each time slot.

Each uploaded and interpolated ramp value is converted into a digital ramp value by a digital-to-analogue converter (DAC) 18, referred to hereafter as the ramp DAC. The output from the ramp DAC 18 is passed through a filter 19 to remove quantization noise and aliases and applied to a power ramping control circuit, not shown, which includes the power amplifier 8.

Currently, there is a trend towards providing functionality that has previously been provided in the baseband processor 9 or in a separate mixed signal IC, in the radio transceiver IC 5. This is partly due to the desirability of incorporating new applications, such as reception of video signals, into communication devices. The ramp circuit 12 is a candidate for such migration, but this gives rise to certain problems, as follows.

Firstly, if the ramp circuit 12 is provided in the radio transceiver IC 5, it is necessary to transmit the ramp values stored in the memory facility 11 to the radio transceiver IC 5 prior to the frame containing the relevant time slot. This must be performed within a finite time and requires sufficient memory within the radio transceiver IC to store the uploaded values. Each ramp value is typically a control word with a length of 10 bits. Therefore, in addition to requiring the ramp DAC 18 to have a width of at least 10 bits, this requires the upload and storage of 320 bits by the radio transceiver IC 5 for each time slot. In a typical GSM GPRS system, there may be up to four slots per frame, requiring 1280 bits to be uploaded prior to transmission. Future systems may be configured with more slots per frame, requiring the upload of a commensurately greater number of bits. The time required to upload the ramp data would increase accordingly, reducing the portion of the time slot available for data transmission.

US 6,169,886 discloses a wireless communication device comprising a ramp generator located in a baseband processor of the device, which defines a ramp based on a maximum power level and a plurality of scaling factors.

One object of the present invention is the provision of a method that facilitates quick uploading of ramp data, without requiring extra memory to be provided in a radio transceiver IC and without sacrificing the accuracy with which the maximum power level is defined.

Accordingly, the present invention provides a wireless communication device comprising:
a baseband portion comprising a baseband processor;
a radio portion comprising a radio transceiver integrated circuit; and
a ramp circuit for controlling power supplied by a transmitter comprising:
   a data storage facility for storing a plurality of ramp values; and
   a digital-to-analogue converter for generating an output signal based on said ramp values;
wherein the digital-to-analogue converter is arranged to receive a first signal corresponding to a predetermined one of said ramp values and a second signal corresponding to a scaling factor derived from said ramp values and to generate the output signal based on the first and second signals;
characterised in that:
the radio portion and the baseband portion communicate via a digital interface and in that the ramp circuit comprises part of the radio transceiver integrated circuit and is configured to upload the ramp values from the baseband portion and further comprises an interpolator for generating the second signal based on two or more of said plurality of ramp values.

In this manner, the ramp data comprises two types of ramp value. The first type is a control word relating to a predetermined power level. For example, the first type may be a control word specifying a maximum power level for that time slot, which is equivalent to the 16^{th} ramp up value in prior art systems. The second type is a scaling factor for the predetermined power level. The stored ramp data therefore defines one or more ramp values in terms of factors by which the predetermined power level is to be scaled.

The first type of ramp data may be defined using a greater number of bits than the second type. This may permit the amount of memory required within the ramp circuit to be reduced, when compared with the prior art arrangement, without reducing resolution of its output.

The ramp circuit may comprise two DACs, the first of which is arranged to control a multiplication factor, and therefore the output voltage range, of the second. The first and second DACs may therefore be of a reduced width when compared with the ramp DAC shown in the prior art arrangement of Figure 1.

The ramp circuit may latch the input of the second DAC when a maximum power level is to be supplied. Where the output of the second DAC is supplied to a power amplifier, this latching ensures that the output of a power amplifier is not affected by any oversampling ratio (OSR) clock noise.

Preferably, the second DAC is arranged to oversample the ramp data, thereby increasing its effective dynamic range and reducing the word length required for some or all of the ramp data.

The transmitter or transceiver may be arranged to transmit data using a Time Division Multiple Access scheme. The wireless communication device may be arranged to transmit data over a telephone network.

The present invention also provides a method of supplying power in a wireless communication device comprising a baseband portion comprising a baseband processor and a radio portion, the radio portion including a radio transceiver integrated circuit comprising:
uploading a plurality of ramp values from the baseband portion;
storing the ramp values in a data storage facility in the radio portion, wherein the following steps are carried out in the radio portion;
generating a first signal corresponding to a predetermined one of said ramp values;
generating a second signal corresponding to a scaling factor derived from said ramp values based on an interpolation of two or more of said plurality of ramp values;
generating an analogue output signal based on the first signal and second signals; and
controlling the power supplied to a power amplifier in accordance with said output signal.

The method may comprise generating a constant output signal corresponding to said predetermined one of said ramp values during a predetermined time interval, for example, generating an output signal associated with a maximum power level during a portion of a time slot used for transmitting data in a TDMA scheme.

This aspect also provides a method of transmitting data comprising generating data for transmission, amplifying a data signal carrying said data using a power amplifier and transmitting said data signal, wherein the step of amplifying said data signal comprises said method of supplying power in a transmitter.

Embodiments of the invention will now be described with reference to the accompanying drawings, in which:
Figure 1 is a block diagram of a prior communication device;
Figure 2 is a graph showing an example set of ramp up and ramp down values;
Figure 3 is a block diagram of a ramp circuit provided in the prior communication device of Figure 1;
Figure 4 is a block diagram of a communication device according to the present invention;
Figure 5 is a ramp circuit according to the present invention;

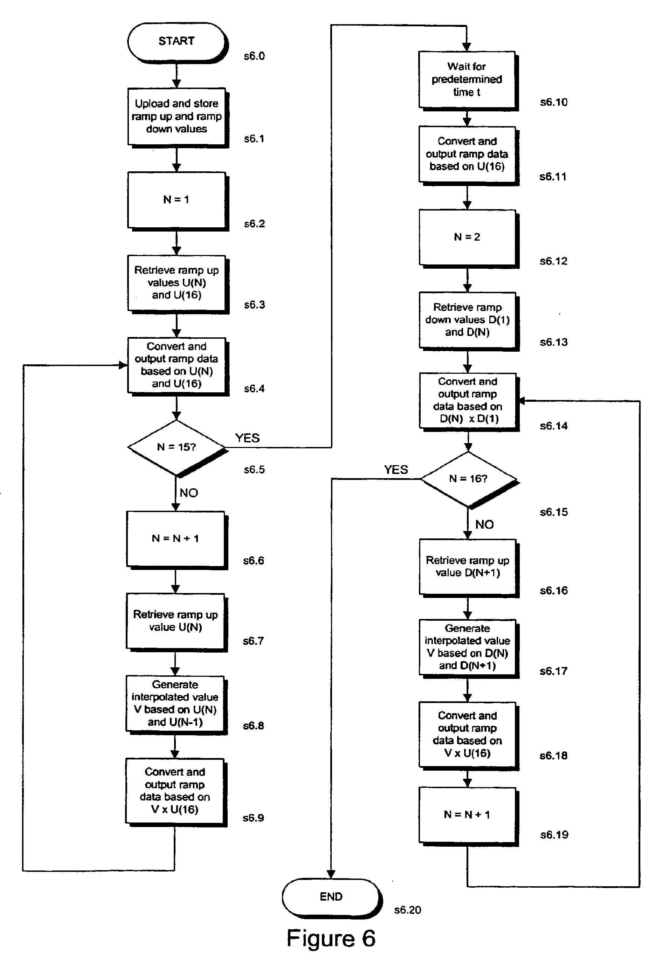

Figure 6 is a flowchart of a procedure for generating ramp data; and
Figure 7 is a graph showing a gain of a power amplifier controlled by the ramp circuit of Figure 5.

Figure 4 depicts a communication device 20 according to the invention which, in this example, is a mobile telephone. As in the prior communication device 1 shown in Figure 1, the mobile telephone 20 comprises a radio portion 21 and a baseband portion 22. The radio portion 21 comprises a radio transceiver IC 25 and a front end module 26 for transmitting and receiving data via an antenna 27. A power amplifier 28 is provided for powering a transmitter portion of the front end module 26.

Unlike the prior communication device 1, the baseband portion 22 comprises only a digital baseband processor 29, which communicates with a memory facility 30. Therefore, the radio portion 21 and baseband portion 22 communicate via a digital interface 31, rather than an analogue interface. A number of the functions performed by the analogue baseband processor 9 of the prior communication device 1 are provided by the radio transceiver IC 25. These functions include the provision of ramp data to a power control circuit, not shown, which includes the power amplifier 28, at the start and end of given time slots.

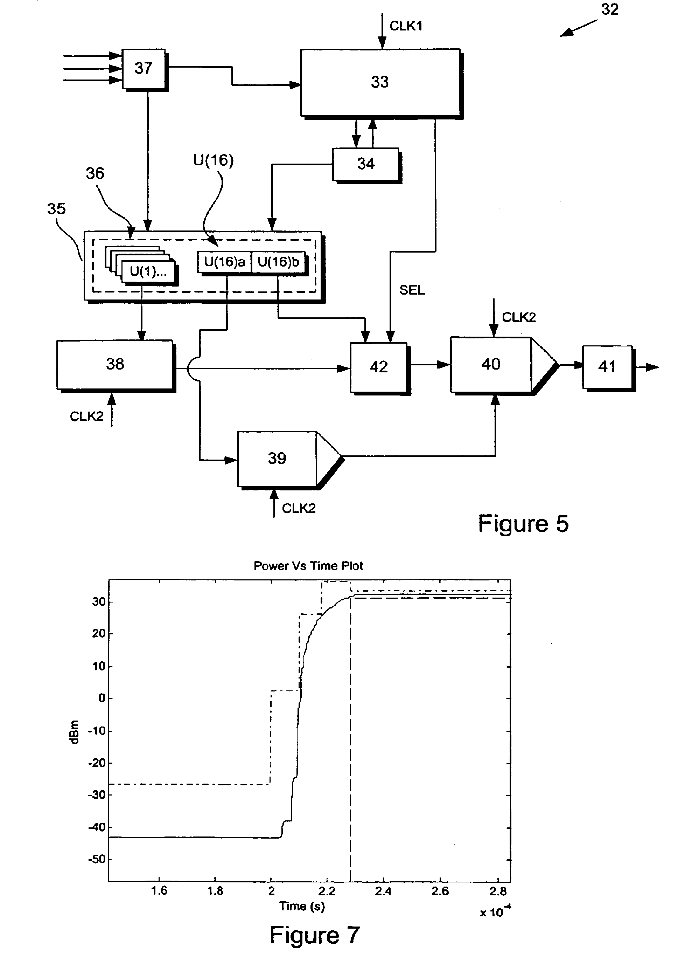

Figure 5 depicts a ramp circuit 32 according to the present invention. The ramp circuit 32 comprises a ramp control circuit 33 and a counter 34. The ramp control circuit 33 controls the generation and application of ramp data to the power control circuit. This procedure includes the generation of a selection signal SEL. The selection signal SEL is in one of two states, depending on whether the output of the ramp circuit 32 relates to a static portion of a time slot, for example, during a portion of the time slot used for transmitting data, in which the power supplied to the transmitter portion remains at a constant level, or if the output relates to a dynamic portion of the time slot in which the power supply to the transmitter portion is ramped up or down.

The ramp circuit 32 comprises a data storage facility 35 for receiving a set of ramp values 36 uploaded from the memory facility 30 via a serial interface 37 and storing them. In this example, the ramp data values 36 comprise 16 ramp up values U(1)-U(16) and 16 ramp down values D(1)-D(16). For reasons of simplicity, only the ramp up values U(1)-U(16) are depicted in Figure 5.

The ramp up values U(1)-U(16) comprise a ten bit control word U(16) that determines a power level that will be supplied to the power amplifier 28 during the static portion of the time slot. Fifteen five bit words U(1)-U(15) each define a power level for the dynamic portion of the time slot during which the power to the transmitter portion is increased. Each of the five bit words U(1)-U(15) define a factor by which the static power level determined by U(16) is scaled in order to produce a desired power level.

In this particular example, the ramp down values D(1)-D(16) are defined similarly to the ramp up values U(1)-U(16). However, it is not necessary for the number of ramp down values D(1)-D(16) to match the number of ramp up values U(1)-U(16). For example, fewer ramp down values may be required as ramping down is less problematical than ramping up. When ramping up, it is necessary to prevent overshooting of the static power level, arising from loop dynamics and power amplifier saturation effects. Such considerations do not apply when ramping down. In addition, a reduced number of ramp down values may be needed if the ramp down shape differs from the ramp up shape. For example, if the transmitter is to be ramped up again in a time slot that immediately follows the present time slot, it may not be necessary to switch off the transmitter at the end of the present time slot. Instead, the power supplied to the transmitter may instead be reduced to a low level, requiring fewer ramp values. Similarly, the ramp data for the following time slot may include a reduced number of ramp up values for the same reason.

Furthermore, it is not necessary for the ramp down values D(1)-D(16) to include a ten bit word defining a static power level. In other embodiments of the invention, the ramp down values may simply be a set of five bit words to be used in conjunction with the static power level defined by U(16).

The ramp circuit 32 also comprises an interpolator 38, such as a Cascade Integrator Comb (CIC) interpolator, for generating interpolated ramp based on the ramp values 36 stored in the data storage facility 35.

Two DACs 39, 40 are provided. In this particular example, each DAC 39, 40 has a 5-bit width. The first DAC 39 is arranged to control the output voltage range of the second DAC 40. The output from the second DAC 40 is passed through a low pass filter 41, and then applied to a power control circuit, not shown, which includes the power amplifier 28.

Uploaded and interpolated ramp values output from the interpolator 38, the control word U(16) and the selection signal SEL are input to a multiplexer 42. The output from the multiplexer 42 is input to the second DAC 40.

A procedure for generating ramp data will now be described. At the start of a transmission time slot (step s6.0), the ramp values 36, U(1) to U(16) and D(1) to D(16), for that time slot are uploaded and stored in the data storage facility 35 (step s6.1).

The counter 34 is initialised (step s6.2) and the first ramp up value U(1) is retrieved, together with the control word U(16), which determines the static power level (step s6.3). The first five bits U(16)a, that is, the five most significant bits (msbs), of the control word U(16) are input to the first DAC 39. The first ramp up value U(1) is passed to the interpolator 38 and output to the second DAC 40 via the multiplexer 42. The second DAC 40 outputs the product of the msbs U(16)a, received from the first DAC 39, and the first ramp up value U(1) (step s6.4). This output is filtered and applied to the power control circuit.

If the counter has a value that is less than 15 (step s6.5), the count is then increased by 1 (step s6.6). The next ramp up value U(2) is retrieved (step s6.7) and passed to the interpolator 38. The interpolator 38 generates and outputs an interpolated value V based on U(1) and U(2) (step s6.8). The second DAC 40 outputs the product of the msbs U(16)a and the interpolated value V (step s6.9).

In this particular example, the interpolator 38 is used to increase the sample rate by a factor of 2 and so the next data value output by the second DAC 36 corresponds to the product of the msbs U(16)a and the second ramp up value U(2) (step s6.4). As the counter value is still less than 15 (step s6.5), the count is then increased (step s6.6) and the third ramp up value U(3) retrieved (step s6.7). An interpolated value V is generated based on U(2) and U(3) (step s6.8) and input to the second DAC 40, which outputs the product of the msbs U(16)a and the interpolated value V (step s6.9) and so on.

After the second DAC 40 has output a product of the fifteenth ramp up value U(15) and the msbs U(16)a (step s6.4), the counter value is equal to 15 at step s6.5. When a predetermined time interval t has elapsed from the application of this to the power control circuit (step s6.10), determined on the basis of a clock signal CLK 1, the ramp control circuit 33 changes the state of the selection signal SEL to indicate the start of the static portion of the time slot. This causes the multiplexer 42 to output the five least significant bits (lsbs) U(16)b of the sixteenth ramp up value U(16) to the second DAC 40. The output of the second DAC 40 is then determined by the sixteenth ramp up value U(16) (step s6.11). The ramp circuit 31 is latched for the duration of the static portion of the time slot to avoid noise from the clock signals CLK2 supplied to the interpolator 38 and the DACs 39, 40.

In this manner, the power level for the static portion of the time slot is defined by the sixteenth ramp up value U(16) with 10 bit accuracy. In addition, as the ramp circuit 32 is latched for the duration of this period, no interpolator noise is produced.

Figure 7 is a graph showing the gain of the power amplifier 28 with respect to time, where the gain is controlled by the uploaded and interpolated ramp up values output by the second DAC 40, together with limits imposed by the GSM specification.
The gain of the power amplifier 28 is shown as a solid line. The dotted-dashed line indicates limits relating to switching transient noise, while the dashed line indicates the static portion of the time slot.

When the static portion of the time slot has elapsed, the counter is reset (step s6.12) and the first and second ramp down values D(1) and D(2) are retrieved from the data storage facility 35 (step s6.13) by the interpolator 38. The second DAC 40 then produces an output based on the product of the second ramp data value D(2) and the five msbs of the first ramp down value D(1) (step s6.14).

As the counter value is less than 16 (step s6.15), the next ramp data value D(3) is retrieved and an interpolated value V is generated, based on D(2) and D(3) (step s6.16). The second DAC 40 then outputs ramp data based on the product of the first ramp down value D(1) and the interpolated value V (step s6.17).

By increasing the count (step s6.18) and repeating steps s6.14 to s6.17, the ramp circuit 32 outputs ramp data based on the ramp down values D(3) to D(16) and interpolated values thereof.

When the counter value is equal to 16 at step s6.15, the procedure is complete (step s6.20). The ramp circuit 32, power control circuit and transmitter portion may then be switched off. However, if it is known that the transmitter portion will be used in the subsequent time slot, the ramp circuit 32, power control circuit and transmitter portion may remain switched on at a low power level. This may be achieved by defining the ramp values 36 accordingly and, if necessary, to define a ramp that is not symmetrical in shape.

In the above example, the sample rate of the ramp data is increased by a factor of two. However, if required, the sample rate may be increased by another factor, for example, the ramp circuit 32 may be arranged to provide up to 23 interpolated values for each pair of ramp up or ramp down values. The interpolator 38 may generate intermediate values based on more than two input ramp up or ramp down values, as required.

Furthermore, while the embodiment related to a ramp circuit 32 within a mobile telephone 20, a ramp circuit 32 according to the present invention may be incorporated in other types of transmitting equipment, including other portable equipment, such as PDAs and laptop computers, as well as fixed equipment, such as base station transmitters.

## Claims

1. A wireless communication device comprising:
a baseband portion (22) comprising a baseband processor (29);
a radio portion (21) comprising a radio transceiver integrated circuit (25); and
a ramp circuit (32) for controlling power supplied by a transmitter comprising:
a data storage facility (35) for storing a plurality of ramp values (36); and
a digital-to-analogue converter (40) for generating an output signal based on said ramp values (36);
wherein the digital-to-analogue converter (40) is arranged to receive a first signal corresponding to a predetermined one of said ramp values (36) and a second signal corresponding to a scaling factor derived from said ramp values (36) and to generate the output signal based on the first and second signals;
**characterised in that**:
the radio portion (21) and the baseband portion (22) communicate via a digital interface (31) and **in that** the radio transceiver integrated circuit (25) comprises the ramp circuit (32) that is configured to upload the ramp values (36) from the baseband portion (22) and further comprises an interpolator (38) for generating the second signal based on two or more of said plurality of ramp values (36).

2. A wireless communication device according to claim 1, wherein the ramp circuit (32) comprises latching means (33) for latching said ramp circuit so that the level of the output signal is constant.

3. A wireless communication device according to claim 1 or 2, wherein said predetermined one of said ramp values (36) relates to a predetermined power level.

4. A wireless communication device according to any one of the preceding claims, further comprising a power amplifier (28) wherein the ramp circuit (32) is configured to control an output of said power amplifier (28).

5. A wireless communication device according to any one of the preceding claims, arranged to transmit data using a Time Division Multiple Access scheme.

6. A wireless communication device (20) according to any one of the preceding claims, arranged to transmit data over a telephone network.

7. A method of supplying power in a wireless communication device comprising a baseband portion (22) comprising a baseband processor (29) and a radio portion (21), the radio portion (21) including a radio transceiver integrated circuit (25), comprising:
uploading a plurality of ramp values (36) from the baseband portion (22);
storing the ramp values in a data storage facility (35) in the radio portion (21), wherein the following steps are carried out in the radio portion (21);
generating a first signal corresponding to a predetermined one of said ramp values;
generating a second signal corresponding to a scaling factor derived from said ramp values based on an interpolation of two or more of said plurality of ramp values (36);
generating an analogue output signal based on the first signal and second signals; and
controlling the power supplied to a power amplifier (28) in accordance with said output signal.

8. A method according to claim 7, comprising generating a constant output signal corresponding to said predetermined one of said ramp values (36) during a predetermined time interval.

9. A method of transmitting data comprising:
generating data for transmission;
amplifying a data signal carrying said data using a power amplifier (38); and
transmitting said data signal;
wherein the step of amplifying said data signal comprises a method of supplying power according to claim 7 or 8.

10. A method according to claim 9, wherein said steps of generating, amplifying and transmitting are repeated in accordance with a plurality of predetermined time slots in a Time Division Multiple Access scheme.

## Patentansprüche

1. Drahtlose Kommunikationsvorrichtung, umfassend:
einen Basisbandbereich (22) mit einem Basisbandprozessor (29);
einen Funkbereich (21) mit einer integrierten Funktransceiverschaltung (25);
eine Rampenschaltung (32) zum Steuern von durch einen Sender zugeführter Leistung, umfassend:
eine Datenspeichereinrichtung (35) zum Speichern einer Vielzahl von Rampenwerten (36); und
einen Digital-zu-Analog-Wandler (40) zum Erzeugen eines Ausgangssignals basierend auf den Rampenwerten (36);
wobei der Digital-zu-Analog-Wandler (40) angeordnet und eingerichtet ist, um ein erstes Signal entsprechend einem vorbestimmten der Rampenwerte (36) und ein zweites Signal entsprechend einem von den Rampenwerten (36) abgeleiteten Skalierungsfaktor zu empfangen und das Ausgangssignal basierend auf dem ersten und dem zweiten Signal zu erzeugen;
**dadurch gekennzeichnet, dass**:
der Funkbereich (21) und der Basisbandbereich (22) über eine digitale Schnittstelle (31) kommunizieren und dass die integrierte Funktransceiverschaltung (25) die Rampenschaltung (32) aufweist, die konfiguriert ist, um die Rampenwerte (36) vom Basisbandbereich (22) heraufzuladen, und weiterhin einen Interpolator (38) zum Erzeugen des zweiten Signals basierend auf zwei oder mehreren der Vielzahl von Rampenwerten (36) aufweist.

2. Drahtlose Kommunikationsvorrichtung nach Anspruch 1, wobei die Rampenschaltung (32) eine Einrasteinrichtung (33) zum Einrasten der Rampenschaltung aufweist, so dass der Pegel des Ausgangssignals konstant ist.

3. Drahtlose Kommunikationsvorrichtung nach Anspruch 1 oder 2, wobei sich der vorbestimmte der Rampenwerte (36) auf einen vorbestimmten Leistungspegel bezieht.

4. Drahtlose Kommunikationsvorrichtung nach einem der vorangehenden Ansprüche, die weiterhin einen Leistungsverstärker (28) aufweist, wobei die Rampenschaltung (32) konfiguriert ist, um eine Ausgabe des Leistungsverstärker (28) zu steuern.

5. Drahtlose Kommunikationsvorrichtung nach einem der vorangehenden Ansprüche, die angeordnet und eingerichtet ist, um Daten unter Verwendung eines Zeitvielfachzugriffsschemas zu senden.

6. Drahtlose Kommunikationsvorrichtung (20) nach einem der vorangehenden Ansprüche, die angeordnet und eingerichtet ist, um Daten über ein Telefonnetzwerk zu senden.

7. Verfahren zum Zuführen von Leistung in einer drahtlosen Kommunikationsvorrichtung umfassend einen Basisbandbereich (22) mit einem Basisbandprozessor (29) und einen Funkbereich (21), wobei der Funkbereich (21) eine integrierte Funktransceiverschaltung (25) enthält, umfassend:
Heraufladen einer Vielzahl von Rampenwerten (36) vom Basisbandbereich (22);
Speichern der Rampenwerte (36) in einer Datenspeichereinrichtung (35) im Funkbereich (21), wobei im Funkbereich (21) die folgenden Schritte ausgeführt werden:
Erzeugen eines ersten Signals entsprechend einem vorbestimmten der Rampenwerte;
Erzeugen eines zweiten Signals entsprechend einem von den Rampenwerten abgeleiteten Skalierungsfaktor basierend auf einer Interpolation von zwei oder mehreren der Vielzahl von Rampenwerten (36);
Erzeugen eines analogen Ausgangssignals basierend auf dem ersten Signal und dem zweiten Signal; und
Steuern der zu einem Leistungsverstärker (28) zugeführten Leistung gemäß dem Ausgangssignal.

8. Verfahren nach Anspruch 7, das ein Erzeugen eines konstanten Ausgangssignals entsprechend dem vorbestimmten der Rampenwerte (36) während eines vorbestimmten Zeitintervalls aufweist.

9. Verfahren zum Senden von Daten, umfassend:
Erzeugen von Daten für ein Senden;
Verstärken eines Datensignals, das die Daten trägt, unter Verwendung eines Leistungsverstärkers (38); und
Senden des Datensignals;
wobei der Schritt zum Verstärken des Datensignals ein Verfahren zum Zuführen von Leistung nach Anspruch 7 oder 8 aufweist.

10. Verfahren nach Anspruch 9, wobei die Schritte zum Erzeugen, Verstärken und Senden gemäß einer Vielzahl von vorbestimmten Zeitschlitzen in einem Zeitvielfachzugriffsschema wiederholt werden.

## Revendications

1. Dispositif de communication sans fil comprenant :
une section de bande de base (22) comprenant un processeur de bande de base (29);
une section radio (21) comprenant un circuit intégré émetteur - récepteur de radio (25); et
un circuit de rampe (32) pour commander la puissance fournie par un émetteur, comprenant :
un moyen de stockage de données (35) pour stocker une multiplicité de valeurs de rampe (36); et
un convertisseur numérique - analogique (40) pour générer un signal de sortie sur la base desdites valeurs de rampe (36);
dans lequel le convertisseur numérique - analogique (40) est agencé pour recevoir un premier signal correspondant à une prédéterminée desdites valeurs de rampe (36) et un deuxième signal correspondant à un facteur d'échelle obtenu à partir desdites valeurs de rampe (36), et pour générer le signal de sortie sur la base des premier et deuxième signaux; **caractérisé en ce que**:
**caractérisé en ce que** :
la section de radio (21) et la section de bande de base (22) communiquent par l'intermédiaire d'une interface numérique (31) et **en ce que** le circuit intégré émetteur - récepteur de radio (25) comprend le circuit de rampe (32) qui est configuré pour charger les valeurs de rampe (36) à partir de la section de bande de base (22) et comprend en outre un interpolateur (38) pour générer le deuxième signal sur la base de deux ou plus de la multiplicité de valeurs de rampe (36).

2. Dispositif de communication sans fil selon la revendication 1, dans lequel le circuit de rampe (32) comprend un moyen de verrouillage (33) pour verrouiller le circuit de rampe de façon que le niveau du signal de sortie soit constant.

3. Dispositif de communication sans fil selon la revendication 1 ou 2, dans lequel ladite valeur prédéterminée parmi les valeurs de rampe (36) se rapporte à un niveau de puissance prédéterminé.

4. Dispositif de communication sans fil selon l'une quelconque des revendications précédentes, comprenant en outre un amplificateur de puissance (28), dans lequel le circuit de rampe (32) est configuré pour commander un signal de sortie dudit amplificateur de puissance (28).

5. Dispositif de communication sans fil selon l'une quelconque des revendications précédentes, agencé pour émettre des données en utilisant une technique d'Accès Multiple par Répartition dans le Temps.

6. Dispositif de communication sans fil (20) selon l'une quelconque des revendications précédentes, agencé pour émettre des données sur un réseau téléphonique.

7. Procédé pour fournir de la puissance dans un dispositif de communication sans fil comprenant une section de bande de base (22) comprenant un processeur de bande de base (29) et une section de radio (21), la section de radio (21) incluant un circuit intégré émetteur - récepteur de radio (25), comprenant les étapes suivantes :
charger une multiplicité de valeurs de rampe (36) à partir de la section de bande de base (22);
stocker les valeurs de rampe dans un moyen de stockage de données (35) dans la section de radio (21), dans lequel les étapes suivantes sont exécutées dans la section de radio (21);
générer un premier signal correspondant à une prédéterminée des valeurs de rampe;
générer un deuxième signal correspondant à un facteur d'échelle obtenu à partir desdites valeurs de rampe, sur la base d'une interpolation de deux ou plus de la multiplicité de valeurs de rampe (36);
générer un signal de sortie analogique sur la base du premier signal et du deuxième signal; et
commander la puissance fournie à un amplificateur de puissance (28) conformément audit signal de sortie.

8. Procédé selon la revendication 7, comprenant la génération d'un signal de sortie constant correspondant à ladite valeur prédéterminée parmi les valeurs de rampe (36) pendant un intervalle de temps prédéterminé.

9. Procédé d'émission de données comprenant les étapes suivantes :
générer des données pour l'émission ;
amplifier un signal de données transportant lesdites données, en utilisant un amplificateur de puissance (38); et émettre ledit signal de données;
dans lequel l'étape d'amplification du signal de données comprend un procédé pour fournir de la puissance conforme à la revendication 7 ou 8.

10. Procédé selon la revendication 9, dans lequel les étapes de génération, d'amplification et d'émission sont répétées conformément à une multiplicité de créneaux temporels prédéterminés dans une technique d'Accès Multiple par Répartition dans le Temps.
